(19) Europäisches Patentamt / European Patent Office / Office européen des brevets

(11) **EP 3 743 998 B1**

(12) **EUROPEAN PATENT SPECIFICATION**

(45) Date of publication and mention
of the grant of the patent:
**12.11.2025 Bulletin 2025/46**

(21) Application number: **18701466.7**

(22) Date of filing: **24.01.2018**

(51) International Patent Classification (IPC):
$H03F\ 1/32$ (2006.01)  $H03F\ 3/189$ (2006.01)
$H03F\ 3/24$ (2006.01)  $H03F\ 3/68$ (2006.01)
$H04B\ 17/10$ (2015.01)  $H04B\ 17/13$ (2015.01)

(52) Cooperative Patent Classification (CPC):
**H03F 1/3247; H03F 3/189; H03F 3/24; H03F 3/68;
H04B 17/103; H04B 17/13; H03F 2201/3233;
H04B 2001/0425**

(86) International application number:
**PCT/EP2018/051667**

(87) International publication number:
**WO 2019/145026 (01.08.2019 Gazette 2019/31)**

(54) **LINEARIZATION OF NON-LINEAR AMPLIFIERS**

LINEARISIERUNG NICHTLINEARER VERSTÄRKER

LINÉARISATION D'AMPLIFICATEURS NON LINÉAIRES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**02.12.2020 Bulletin 2020/49**

(73) Proprietor: **TELEFONAKTIEBOLAGET LM
ERICSSON (PUBL)
164 83 Stockholm (SE)**

(72) Inventors:
• **HAUSMAIR, Katharina
416 71 Göteborg (SE)**
• **GUSTAVSSON, Ulf
413 13 Göteborg (SE)**
• **ERIKSSON, Thomas
423 43 Göteborg (SE)**
• **FAGER, Christian
435 38 Mölnlycke (SE)**

(74) Representative: **Ericsson
Patent Development
Torshamnsgatan 21-23
164 80 Stockholm (SE)**

(56) References cited:
**WO-A1-2016/132237      WO-A1-2017/198288
WO-A1-2019/117771      KR-A- 20140 124 178
US-A1- 2012 328 050**

• **PRATA ANDRE ET AL: "Towards circulator-free
multi antenna transmitters for 5G", 2017 IEEE
MTT-S INTERNATIONAL MICROWAVE
SYMPOSIUM (IMS), IEEE, 4 June 2017
(2017-06-04), pages 677 - 680, XP033159793, DOI:
10.1109/MWSYM.2017.8058661**
• **FAGER CHRISTIAN ET AL: "Prediction of smart
antenna transmitter characteristics using a new
behavioral modeling approach", 2014 IEEE MTT-
S INTERNATIONAL MICROWAVE SYMPOSIUM
(IMS2014), IEEE, 1 June 2014 (2014-06-01), pages
1 - 4, XP032615052, DOI: 10.1109/
MWSYM.2014.6848309**

## Description

### TECHNICAL FIELD

The present disclosure relates generally to the field of wireless communication. More particularly, it relates to linearization of non-linear amplifiers.

### BACKGROUND

Large multi-antenna systems (e.g. advanced antenna systems, AAS) are increasingly applied in wireless communication, for example, in relation to fifth generation (5G) systems such. A wireless transmitter node (e.g. a radio base station, RBS) equipped with multiple (potentially tens, hundreds, or even more) transmitter branches entails both challenges and opportunities in terms of radio signal processing as is well known in the art.

One challenge is that of increased implementation complexity, particularly regarding the parts of the wireless transmitter node which are associated with radio signal processing (e.g. digital pre-distortion, DPD). One cost of implementation associated with DPD is the transmit observation receiver (TOR), or transmit observation receivers, which is used for monitoring power amplifier output and to extract measurement data for the DPD.

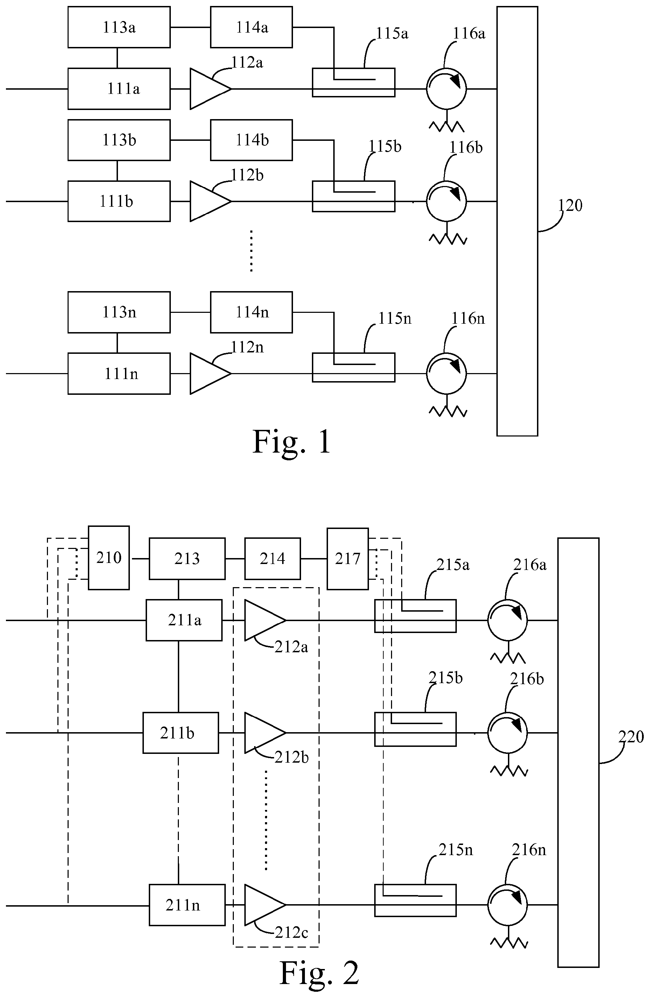

Figure 1 schematically illustrates an example arrangement according to the prior art where each individual transmitter branch (1, b, ..., n) is monitored by a dedicated TOR 114a, 114b, ..., 114n. The output of each power amplifier (PA) 112a, 112b, ..., 112n is provided to an antenna array 120 for transmission, and is fed back to the respective TOR 114a, 114b, ..., 114n using a respective circulator 116a, 116b, ..., 116n and a respective directional coupler 115a, 115b, ..., 115n.

The signal received by the respective TOR 114a, 114b, ..., 114n is provided to a respective parameter estimator 113a, 113b, ..., 113n, which estimates parameters to be used by a respective actuator 111a, 111b, ..., 111n for digital pre-distortion of a signal input to the respective PA 112a, 112b, ..., 112n with the aim of compensating for non-linarites of the respective PA 112a, 112b, ..., 112n.

The solution of Figure 1 becomes increasingly complex as the number of transmit antenna elements, and thereby the number of transmitter branches, increases since the number of TOR:s increases in the same manner.

Figure 2 schematically illustrates an example arrangement according to the prior art where the transmitter branches (1, b, ..., n) are monitored by a shared TOR 214. The output of each power amplifier (PA) 212a, 212b, ..., 212n is provided to an antenna array 220 for transmission, and is fed back to the shared TOR 214 using a respective circulator 216a, 216b, ..., 216n and a respective directional coupler 215a, 215b, ..., 215n.

The signal received by the shared TOR 214 is provided to a parameter estimator 213, which estimates parameters to be used by a respective actuator 211a, 211b, ..., 211n for digital pre-distortion of a signal input to the respective PA 212a, 212b, ..., 212n with the aim of compensating for non-linarites of the respective PA 212a, 212b, ..., 212n.

The sharing of the TOR 214 between the transmitter branches may be accomplished by software controlled switchable networks 210, 217 or by any other suitable approach.

The solution of Figure 2 also becomes increasingly complex as the number of transmit antenna elements, and thereby the number of transmitter branches, increases since the sharing (e.g. the software controlled switchable networks) becomes increasingly complex.

Typically, traditional solutions implement an approach where each individual transmitter branch is monitored either by a dedicated TOR (as illustrated in Figure 1) or by a TOR shared with other transmitter branches via a switch and a lossy distribution network (as illustrated in Figure 2). In either case, the implementation is costly in terms of active hardware and signal routing and distribution, which becomes increasingly cumbersome for an increasing number or transmitter branches (i.e. as the number of transmit antenna elements increases).

Thus, pre-distortion (DPD) approaches of the prior art suffers from complexity issues; in terms of the number of TOR:s and/or in terms of the size of the switchable networks for TOR sharing. Furthermore, the approaches in Figures 1 and 2 both require individual directional couplers per transmitter branch, which typically increases both size and cost of the implementation, and introduces additional losses.

Another issue encountered for conventional pre-distortion (DPD) approaches is the effects emanating from mutual coupling between antennas; see for example S. Choi, E.-R. Jeong; "Digital Predistortion Based on Combined Feedback in MIMO Transmitters", IEEE Communication Letters, vol. 16, no. 10, pp. 1572-1575, October 2012.

Therefore, there is a need for novel and alternative approaches to linearization of non-linear amplifiers. Preferably, approaches which are less complex than solutions of the prior art when applied to large antenna arrays and which also provides handling of mutual coupling between antennas.

WO 2017/198288 A1 describes an apparatus for identification and compensation of distortion in a multi-antenna system.

"Towards Circulator-Free Multi Antenna Transmitters for 5G" by A. Prata, et al., 2017 IEEE MTT-S International Microwave Symposium, pp. 677-680 proposes a solution to remove the circulator on multi-antenna transmitters.

WO 2016/132237 A1 describes a method to improve active antenna system performance in the presence of mutual coupling.

US 2012/0328050 A1 describes a centralized adaptor architecture for power amplifier linearizations in advanced wireless communication systems.

"Prediction of Smart Antenna Transmitter Characteristics Using a New Behavioral Modeling Approach" by C. Fager et al., 2014 IEEE MTT-S International Microwave Symposium, pp. 1-4 describes a technique for analysis for nonlinear effects in smart antenna array transmitter systems.

KR 2014/0124178 A describes pre-distortion for a MIMO transmitter.

WO 2019/117771 A1 - which is a document under Article 54(3) EPC - describes a linearization device for linearization of non-linear amplifiers.

**SUMMARY**

It should be emphasized that the term "comprises/comprising" when used in this specification is taken to specify the presence of stated features, integers, steps, or components, but does not preclude the presence or addition of one or more other features, integers, steps, components, or groups thereof. As used herein, the singular forms "a", "an" and "the" are intended to include the plural forms as well, unless the context clearly indicates otherwise.

It is an object of some embodiments to solve or mitigate, alleviate, or eliminate at least some of the above or other disadvantages.

According to a first aspect, this is achieved by a linearization device configured to determine pre-distortion parameters associated with a plurality of non-linear amplifiers. Each of the non-linear amplifiers is associated with a respective one of a plurality of transmit antenna elements and with a non-linear transfer function defining an output of the non-linear amplifier based on an input of the non-linear amplifier and based on a reflection signal for the non-linear amplifier, resulting from mutual couplings among the plurality of transmit antenna elements.

The linearization device comprises a first port configured to receive a plurality of channel coefficients indicative of channel characteristics of a plurality of communication paths between the plurality of non-linear amplifiers and two or more transmit observation receivers. Each transmit observation receiver is configured to receive a sum of transmission signals generated by the plurality of non-linear amplifiers and transferred over the communication paths between the plurality of non-linear amplifiers and the transmit observation receiver.

The linearization device also comprises a second port configured to receive the sums of transmission signals from the transmit observation receivers.

Furthermore, the linearization device also comprises determination circuitry configured to determine the pre-distortion parameters based on the received plurality of channel coefficients, the received sums of transmission signals, and a model of the non-linear transfer functions of the non-linear amplifiers, wherein the pre-distortion parameters are for compensation of the non-linear transfer functions of the plurality of non-linear amplifiers.

In some embodiments, the model is represented, for each of the non-linear amplifiers, by a plurality of amplifying coefficients in a space spanned by a regression matrix of the inputs and the reflection signals.

In some embodiments, each reflection signal is modelled as a linear function of the outputs of the plurality of non-linear amplifiers, the linear function being defined by reflection coefficients.

In some embodiments, wherein the two or more transmit observation receivers comprise three or more transmit observation receivers, the determination circuitry is further configured to determine the reflection coefficients by defining initial reflection coefficients, determining intermediate amplifying coefficients based on the initial reflection coefficients, determining intermediate reflection coefficients based on the intermediate amplifying coefficients, and recursively determining refined amplifying coefficients based on previous reflection coefficients and refined reflection coefficients based on previous amplifying coefficients.

In some embodiments, the linearization device is configured to determine the pre-distortion parameters based on the amplifying coefficients.

In some embodiments, the linearization device is configured to determine the amplifying coefficients based on $N$ samples of the sums of transmission signals received by the transmit observation receivers via $L$ receive antenna ports by determining, for each of the plurality of non-linear amplifiers, a Kronecker product between a column vector having as elements the corresponding estimated channel coefficients and the regression matrix, calculating a generalized pseudo-inverse of a matrix formed by concatenating the determined Kronecker products of the plurality of non-linear amplifiers, and determining a matrix product between the calculated generalized pseudo-inverse and a column vector having as elements the $N$ samples of the sums of transmission signals from each of the $L$ receive antenna ports.

In some embodiments, the plurality of communication paths are radio communication paths between the plurality of non-linear amplifiers and the transmit observation receivers via a corresponding plurality of transmit antenna elements and at least two receive antenna elements.

A second aspect is an arrangement for a wireless transmitter node, the wireless transmitter node comprising at least two receive antenna ports, each connectable to a corresponding receive antenna element, and a plurality of transmit antenna ports, each connectable to a corresponding transmit antenna element of an active antenna array having a plurality of transmit antenna elements.

Each transmit antenna port is associated with a respective transmitter branch, wherein each transmitter branch comprises a non-linear amplifier and digital pre-distortion circuitry.

The non-linear amplifier is associated with a respective one of the plurality of transmit antenna elements and with a non-linear transfer function defining an output of the non-linear amplifier based on an input of the non-linear amplifier and based on a reflection signal for the non-linear amplifier, resulting from mutual couplings among the plurality of transmit antenna elements.

The digital pre-distortion circuitry is configured to compensate the non-linear transfer function by pre-distorting the signal of the transmitter branch based on pre-distortion parameters.

The arrangement comprises a channel estimator, two or more transmit observation receivers, and the linearization device of the first aspect.

The channel estimator is configured to estimate a plurality of channel coefficients indicative of channel characteristics of a plurality of communication paths between the plurality of non-linear amplifiers and two or more transmit observation receivers.

Each of the two or more transmit observation receivers is associated with one of the at least two receive antenna ports and configured to receive a sum of transmission signals generated by the plurality of non-linear amplifiers and transferred over the communication paths between the plurality of non-linear amplifiers and the transmit observation receiver.

The linearization device has the first port connected to the channel estimator and the second port connected to the transmit observation receiver. Furthermore, the linearization device is configured to provide the determined pre-distortion parameters to the digital pre-distortion circuitry of the transmitter branches.

In some embodiments, the arrangement further comprises the at least two receive antenna ports and the at least two receive antenna elements.

A third aspect is a wireless transmitter node comprising at least one of the linearization device of the first aspect and the arrangement of the second aspect.

A fourth aspect is a cloud based server node comprising the linearization device of the first aspect, wherein the cloud based server node is configured to provide the determined pre-distortion parameters to a wireless transmitter node.

A fifth aspect is a method for a linearization device for determining pre-distortion parameters associated with a plurality of non-linear amplifiers, each associated with a respective one of a plurality of transmit antenna elements and with a non-linear transfer function defining an output of the non-linear amplifier based on an input of the non-linear amplifier and based on a reflection signal for the non-linear amplifier, resulting from mutual couplings among the plurality of transmit antenna elements.

The method comprises receiving, via a first port of the linearization device, a plurality of channel coefficients indicative of channel characteristics of a plurality of communication paths between the plurality of non-linear amplifiers and two or more transmit observation receivers, wherein each transmit observation receiver is configured to receive a sum of transmission signals generated by the plurality of non-linear amplifiers and transferred over the communication paths between the plurality of non-linear amplifiers and the transmit observation receiver.

The method also comprises receiving, via a second port of the linearization device, the sums of transmission signals from the transmit observation receiver, and determining the pre-distortion parameters based on the received plurality of channel coefficients, the received sums of transmission signals, and a model of the non-linear transfer functions of the non-linear amplifiers, wherein the pre-distortion parameters are for compensation of the non-linear transfer functions of the plurality of non-linear amplifiers.

In some embodiments, the method further comprises estimating the plurality of channel coefficients.

A sixth aspect is a computer program product comprising a non-transitory computer readable medium, having thereon a computer program comprising program instructions. The computer program is loadable into a data processing unit and configured to cause execution of the method according to the fifth aspect when the computer program is run by the data processing unit.

In some embodiments, any of the above aspects may additionally have features identical with or corresponding to any of the various features as explained above for any of the other aspects.

An advantage of some embodiments is that a lower complexity may be achieved than for approaches according to the prior art, in particular for an increasing number of transmit antenna elements. The complexity may, for example, be defined in terms of one or more of: the number of TOR:s, the complexity (e.g. size) of a switching network, and the number of directional couplers.

Another advantage of some embodiments is that mutual coupling between antennas can be taken into account. Typically, this advantage leads to a higher accuracy of the linearization.

## BRIEF DESCRIPTION OF THE DRAWINGS

Further objects, features and advantages will appear from the following detailed description of embodiments, with reference being made to the accompanying drawings. The drawings are not necessarily to scale, emphasis instead being placed upon illustrating the example embodiments.

Figure 1 is a schematic block diagram illustrating an example arrangement according to the prior art;

Figure 2 is a schematic block diagram illustrating an example arrangement according to the prior art;

Figure 3 is a schematic block diagram illustrating an example arrangement according to some embodiments;

Figure 4 is a flowchart illustrating example method steps according to some embodiments; and

Figure 5 is a schematic drawing illustrating an example computer readable medium according to some embodiments.

## DETAILED DESCRIPTION

As already mentioned above, it should be emphasized that the term "comprises/comprising" when used in this specification is taken to specify the presence of stated features, integers, steps, or components, but does not preclude the presence or addition of one or more other features, integers, steps, components, or groups thereof. As used herein, the singular forms "a", "an" and "the" are intended to include the plural forms as well, unless the context clearly indicates otherwise.

Embodiments of the present disclosure will be described and exemplified more fully hereinafter with reference to the accompanying drawings. The solutions disclosed herein can, however, be realized in many different forms and should not be construed as being limited to the embodiments set forth herein.

In the following, embodiments will be described where two or more TOR:s can be used in connection to determination of pre-distortion parameters for a plurality of transmitter branches without the need for directional couplers or switching networks.

Embodiment presented herein also provides for handling of the issue encountered for conventional pre-distortion (DPD) approaches; the effects emanating from mutual coupling between antennas. To this end, some embodiments accommodate a need for isolation between transmit branches to cope with the effects of mutual coupling. It may be noted that existing solutions for reduced analog hardware complexity in pre-distortion (DPD) approaches take mutual coupling between antennas into consideration.

This is achieved by (simultaneous) observation of at least two sums of transmission signals, wherein each transmission signal is generated by a respective one of a plurality of non-linear amplifiers and is transferred over the communication path between the non-linear amplifier and the corresponding transmit observation receiver. The channel coefficients indicative of channel characteristics of the plurality of communication paths between the plurality of non-linear amplifiers and the transmit observation receivers may be estimated by any suitable method or may be otherwise known.

The pre-distortion parameters are then determined for the plurality of transmitter branches based on the channel coefficients, the received sums of transmission signals, and a model of non-linear transfer functions of the non-linear amplifiers.

Some embodiments thus provide simplified pre-distortion for antenna arrays with mutual coupling. Embodiments presented herein uses few - typically much fewer than the number of transmission branches - TOR:s (each connected to an observation receiver) to simultaneously identify the pre-distortion parameters for a larger number of different transmit branches, thereby saving cost and/or implementation complexity. Thus, according to some embodiments, the amount of measurement receivers needed to compensate for power amplifier distortion in a large array is reduced compared to prior art approaches.

Furthermore, the mutual coupling between transmit antenna elements is taken into account in the pre-distortion parameter determination as exemplified herein.

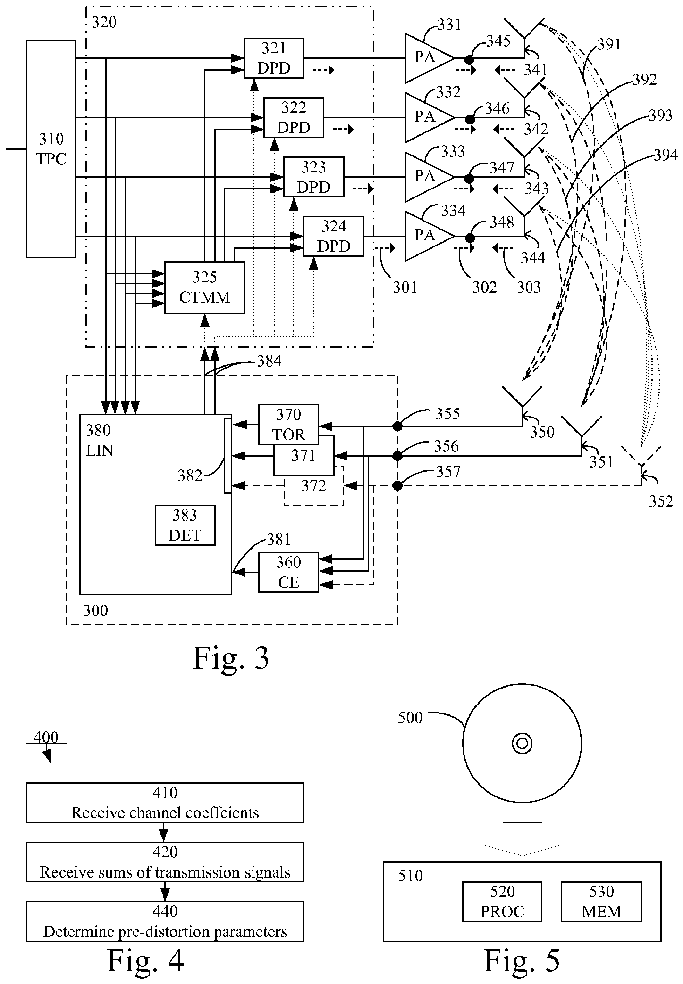

Figure 3 schematically illustrates an example arrangement 300 for a wireless transmitter node according to some embodiments. The wireless transmitter node comprises at least two receive antenna ports 355, 356, 357, each connectable to a corresponding receive antenna element 350, 351, 352, and a plurality (exemplified as four in Figure 3 for illustration) of transmit antenna ports 345, 346, 347, 348, each connectable to a corresponding transmit antenna element of an active antenna array having a plurality of transmit antenna elements 341, 342, 343, 344.

Each transmit antenna port is associated with a respective transmitter branch, wherein each transmitter branch comprises a non-linear power amplifier (PA) 331, 332, 333, 334 associated with a non-linear transfer function and configured to amplify a signal of the transmitter branch.

The non-linear transfer function defines an output of the non-linear amplifier based on an input of the non-linear amplifier and based on a reflection signal for the non-linear amplifier, resulting from mutual couplings among the plurality of transmit antenna elements.

Each transmitter branch also comprises digital pre-distortion circuitry (DPD) 321, 322, 323, 324 configured to compensate the non-linear transfer function by pre-distorting the signal of the transmitter branch based on pre-distortion parameters.

The pre-distortion circuitry may, for example, comprise respective pre-distortion circuitry for each of the transmitter branches as illustrated in Figure 3 or common pre-distortion circuitry shared for all of the transmitter branches (see e.g. 320 of Figure 3). Generally, the pre-distortion circuitry may comprise one or more actuators.

In one typical example, a multi-antenna transmitter DPD (a common pre-distortion circuitry) 320 may comprise one dual-input DPD per transmission branch (the dual inputs being a signal input and a crosstalk input), and one shared crosstalk mismatch model (CTMM) 325 taking the signal input of each DPD as inputs and providing the crosstalk inputs (estimates of the reflected signals) to each DPD. The CTMM may include the coupling (reflection) coefficients for all M transmit paths, the $m^{th}$ dual-input DPD may include DPD coefficients (parameters) for the corresponding PA, and all coefficients are identified (and updated if there is an adaptive algorithm used) by the linearization device 380.

A signal to be transmitted is divided into respective signals to be transmitted by each transmitter branch by a transmit pre-coder (TPC) 310 according to any suitable approach. It may be preferable that the signal to be transmitted comprises a wide range of signal properties (e.g. different amplitudes and/or different frequencies), since such diverse signal properties provides for proper linearization of the non-linear amplifiers.

Typically, but not necessarily, the arrangement 300 is implemented in a different hardware unit than the transmitter branches.

The arrangement 300 comprises at least two transmit observation receivers (TOR) 370, 371, 372, each associated with one of the receive antenna ports 355, 356, 357 and configured to receive a sum of transmission signals generated by the plurality of non-linear amplifiers and transferred over a plurality of communication paths 391, 392, 393, 394 (e.g. radio communication paths) between the plurality of non-linear amplifiers and the transmit observation receiver. In Figure 3, only the communication paths 391, 392, 393, 394 between the plurality of non-linear amplifiers and the transmit observation receiver 370 have been labeled with reference numbers. The communication paths between the plurality of non-linear amplifiers and the other transmit observation receivers 371, 372 are illustrated ad dotted lines without reference number labels.

If the reflection coefficients (thus, at least implicitly, the mutual couplings among the plurality of transmit antenna elements is known) are known, already estimated, or otherwise in no need for being estimated, the arrangement comprises at least two (for example exactly two) transmit observation receivers (TOR).

If the reflection coefficients (and implicitly the mutual couplings among the plurality of transmit antenna elements) are not known, not estimated, or otherwise in need for being estimated, the arrangement comprises at least three (for example exactly three) transmit observation receivers (TOR).

Thus, the wireless transmitter node may comprise two or more receive antenna ports (e.g. as many receive antenna ports as it comprises transmit antenna ports). Typically, a convergence time of the linearization process to be described herein decreases as the number of receive antenna ports increases.

The arrangement 300 also comprises a channel estimator (CE) 360 configured to estimate a plurality of channel coefficients indicative of channel characteristics of the plurality of communication paths.

In various embodiments, the arrangement may also comprise some or all of: the at least two receive antenna ports 355, 356, 357, the at least one receive antenna element 350, 351, 352, the plurality of transmit antenna ports 345, 345, 347, 348, the active antenna array comprising the transmit antenna elements 341, 342, 343, 344, and the transmitter branches.

The arrangement 300 also comprises a linearization device (LIN; e.g. linearization circuitry) 380. The linearization device 380 is configured to determine the pre-distortion parameters associated with the non-linear amplifiers 331, 332, 333, 334 to be used by the digital pre-distortion circuitry 321, 322, 323, 324. To this end, the linearization device comprises a first port 381, a second port 382 and determination circuitry (DET) 383.

Generally, when a linearization device is referred to herein, a linearization device may be defined as a device which is configured to compensate for a distortion in a signal introduced by one or more non-linear components in a radio system. A non-linear component is a component which has an output that is not a linear function of an input of the component. An example of a non-linear component is a non-linear power amplifier, such as the power amplifiers discussed in connection to Figure 3. As mentioned above, each of the non-linear power amplifiers is associated with a non-linear transfer function defining an output of the non-linear amplifier based on an input of the non-linear amplifier and based on a reflection signal for the non-linear amplifier, resulting from mutual couplings among the plurality of transmit antenna elements. Thus, the mutual coupling among the plurality of transmit antenna elements is considered generally herein as subject to the linearization.

The first port 381 is configured to receive a plurality of channel coefficients indicative of channel characteristics of the plurality of communication paths 391, 392, 393, 394 between the plurality of non-linear amplifiers and the transmit observation receivers 370, 371, 372. In the embodiment of Figure 3, the channel coefficients are estimated by and received from the channel estimator 360. It should be noted that the channel coefficients may be determined or estimated in any suitable manner. In some embodiments, the channel coefficients may even be known beforehand.

Generally, when channel coefficients are referred to herein, the channel coefficients may be defined according to any suitable, known or future, approach. For example, each channel coefficient may refer to a complex value which describes a difference (in terms of amplitude and phase) between a transmitted signal and a part of the corresponding signal received at a particular time, wherein different channel coefficients refer to different particular times to, e.g. to describe a multipath channel model which in this case is a model of the plurality of communication paths 391, 392, 393, 394 between the plurality of non-linear amplifiers and the transmit observation receivers 370, 371, 372. Thus, the channel estimation referred to herein is not for access purposes (as is typically the case for channel estimation), but is an estimation of the channel comprising the plurality of communication paths 391, 392, 393, 394 between the plurality of non-linear amplifiers and the transmit observation receiver 370.

Also generally, the communication paths may be wireless (e.g. radio) communication paths and the linearization may be based on over-the-air measurements.

The second port 382 linearization device is configured to receive the sums of transmission signals from the transmit observation receivers 370, 371, 372, and the determination circuitry 383 is configured to determine the pre-distortion parameters based on the received plurality of channel coefficients, the received sums of transmission signals, and a model of the non-linear transfer functions of the non-linear amplifiers.

In the embodiment of Figure 3, the first port 381 is connected to the channel estimator and the second port 382 is connected to the transmit observation receivers. The linearization device is configured to provide the determined pre-distortion parameters, and the determined reflection coefficients (if applicable), to the digital pre-distortion circuitry of the transmitter branches as illustrated by 384 in Figure 3.

In Figure 3, the linearization device 380 (and the arrangement 300) has been illustrated as comprised in a wireless transmitter node. It should be noted that, in other embodiments, the linearization device 380 may be comprised in another node, for example a cloud based server node. In such embodiments, the other node may be configured to provide the determined pre-distortion parameters to a wireless transmitter node for application therein.

Alternatively or additionally, the channel estimator 360 may be comprised in another node than the wireless transmitter node (which other node may be the same or different than the node comprising the linearization device). In such embodiments, the node comprising the channel estimator may be configured to provide the channel coefficients to the node comprising the linearization device for application therein. In fact, the channel coefficients may not even be provided by a channel estimator according to some embodiments, but may be acquired in some other way (e.g. known beforehand).

The determination, by the linearization device, of the pre-distortion parameters will be exemplified in the following. In this context it should be noted that some embodiments provide an approach wherein it is possible to determine the pre-distortion parameters from the sum of transmission signals; i.e. it may not be necessary, or even possible, to separate the individual transmission signals of each respective transmitter branch.

In the following example of the determination of the pre-distortion parameters, it is assumed that there are M transmitter branches, each with a respective non-linear amplifier, the index m identifying the relevant transmitter branch and amplifier, and that there are L receiver ports, each with a respective TOR, the index l identifying the relevant receiver port.

The output from the $m^{th}$ amplifier may be modeled using a non-linear transfer function which describes the input-output relation of the non-linear amplifier. The non-linear transfer function for the $m^{th}$ amplifier defines an output $b_{2m}$, 302, of the non-linear amplifier based on an input $a_{1m}$, 301, of the non-linear amplifier and based on a reflection signal $a_{2m}$, 303, for the non-linear amplifier (the reflected wave injected via mutual coupling), wherein the reflection signal results from mutual couplings among the plurality of transmit antenna elements. The non-linear transfer function for the $m^{th}$ amplifier may be written as: $b_{2m} = f_m(a_{1m}, a_{2m})$.

The above expression of the non-linear transfer function for the $m^{th}$ amplifier may be written in linear matrix-vector form as: $b_{2m} = \mathbf{G}(a_{1m}, a_{2m})\theta_m$, where $\theta_m$ is a vector of amplifying coefficients $\theta_{jm}$ in a (possibly polynomial) model for the $m^{th}$ amplifier, and $\mathbf{G}(a_{1m}, a_{2m})$ is the regression matrix of the $m^{th}$ amplifier (in many cases the regression matrix may be considered to be equal for all amplifiers).

The regression matrix represents a model of the non-linear amplifier. The model is represented by a plurality of amplifying coefficients $\theta_{jm}$ in a space spanned by the regression matrix of the inputs and the reflection signals.

The reflection signal $a_{2m}$ may be expressed as a function of the M different outputs from the power amplifiers: $a_{2m} = h_m(b_{21}, \dots , b_{2M})$, where $h_m$ is a function describing the mutual coupling.

The reflection signal for the $m^{th}$ amplifier may be expressed as a scalar product: $\mathbf{a}_{2m} = \mathbf{b}_2^{\mathrm{T}}\boldsymbol{\lambda}_m$, where $\mathbf{b}_2 = [b_{21}, \dots , b_{2M}]^{\mathrm{T}}$ and $\boldsymbol{\lambda}_m = [\lambda_{m1}, \dots , \lambda_{mM}]^{\mathrm{T}}$ is a vector of reflection coefficients modeling the mutual coupling between the $m^{th}$ transmit antenna element and the other transmit antenna elements. Thus, each reflection signal may be modelled as a linear function (e.g. linear combination) of the outputs of the plurality of non-linear amplifiers, the linear function being defined by reflection coefficients.

The received signal at the $l$th receiver port is measured as the sum: $r_l = \sum_{m=1}^{M} \eta_{lm} b_{2m}$ , where $\eta_{lm}$ is the channel coefficient describing the wireless channel, 391, 392, 393, 304 between the $m$th transmitter and the $l$th TOR. Given the assumptions above, the received signal may be modelled as: $\mathbf{r}_l = \sum_{m=1}^{M} \eta_{lm} \mathbf{G}(\mathbf{a}_{1m}, \mathbf{a}_{2m}) \boldsymbol{\theta}_m$ .

Using a generalized system model (compare with Figure 3) with $L$ measurement receivers (i.e. $L$ receiver antenna ports) and $M$ transmitters, the measurement vector may be written as:

$$
\begin{bmatrix} \mathbf{r}_1 \\ \vdots \\ \mathbf{r}_L \end{bmatrix} = ([\boldsymbol{\eta}_1 \otimes \mathbf{G}(\mathbf{a}_{11}, \mathbf{a}_{21}) \quad \dots \quad \boldsymbol{\eta}_M \otimes \mathbf{G}(\mathbf{a}_{1M}, \mathbf{a}_{2M})]) \begin{bmatrix} \boldsymbol{\theta}_1 \\ \vdots \\ \boldsymbol{\theta}_M \end{bmatrix}
$$

$$
= \begin{bmatrix} \eta_{11} \mathbf{G}(\mathbf{a}_{11}, \mathbf{a}_{21}) & \dots & \eta_{1M} \mathbf{G}(\mathbf{a}_{1M}, \mathbf{a}_{2M}) \\ \vdots & \ddots & \vdots \\ \eta_{L1} \mathbf{G}(\mathbf{a}_{11}, \mathbf{a}_{21}) & \dots & \eta_{LM} \mathbf{G}(\mathbf{a}_{1M}, \mathbf{a}_{2M}) \end{bmatrix} \begin{bmatrix} \boldsymbol{\theta}_1 \\ \vdots \\ \boldsymbol{\theta}_M \end{bmatrix}
$$

where $\mathbf{r}_l$ is the vector of $N$ samples received at the $l$th receive antenna port, $\eta$ represents the channel coefficients, and $\otimes$ is the Kronecker-product.

Thus, $[\eta_1 \otimes \mathbf{G}(\mathbf{a}_{11}, \mathbf{a}_{21}) \dots \eta_M \otimes \mathbf{G}(\mathbf{a}_{1M}, \mathbf{a}_{2M})]$ represents a concatenation of the Kronecker products (of the plurality of non-linear amplifiers) between a column vector having as elements the corresponding estimated channel coefficients and a regression matrix, and $\mathbf{r}$ represents N samples of the sum of transmission signals received by the transmit observation receiver via L receive antenna ports.

Provided that the reflection coefficients modeling the mutual coupling are known, procedure may be used to in identify the amplifier coefficients as:

$$
\begin{bmatrix} \widehat{\boldsymbol{\theta}_1} \\ \vdots \\ \boldsymbol{\theta}_M \end{bmatrix} = \begin{bmatrix} \eta_{11} \mathbf{G}(\mathbf{a}_{11}, \mathbf{a}_{21}) & \dots & \eta_{1M} \mathbf{G}(\mathbf{a}_{1M}, \mathbf{a}_{2M}) \\ \vdots & \ddots & \vdots \\ \eta_{L1} \mathbf{G}(\mathbf{a}_{11}, \mathbf{a}_{21}) & \dots & \eta_{LM} \mathbf{G}(\mathbf{a}_{1M}, \mathbf{a}_{2M}) \end{bmatrix}^{\dagger} \begin{bmatrix} \mathbf{r}_1 \\ \vdots \\ \mathbf{r}_L \end{bmatrix}
$$

wherein $[\cdot]^{\dagger}$ denotes the generalized pseudo-invers, and $\widehat{[\cdot]}$ denotes the least-square estimate of the coefficients.

The estimated amplifier coefficients thus provided may be used in a next step of an iterative procedure further refining the estimate of the amplifier coefficients.

An example of such an iterative procedure for estimating the amplifier coefficients can be illustrated by a pseudo-code function using known reflection coefficients and two over-the-air measurements (i.e. two transmit observation receivers, $L$ = 2) as follows, where *NMSE* denotes the normalized mean square error, and $\widetilde{\boldsymbol{B}}_{2M}^{(0)}$ is an augmented $N \times M$ matrix consisting of all $N \times 1$-dimensional $b_{2m}$ vectors for all $M$ transmit branches:

**known:**   input signals $a_{1m}$

reflection coefficients $\lambda_m$

channel coefficients $\eta_{1m}, \eta_{2m}$

**measured:** received signals $\mathbf{r}_1, \mathbf{r}_2$

$NMSE_{des} = X,$          [define desired accuracy]

$NMSE = \infty,$

$\widetilde{\boldsymbol{B}}_{2M}^{(0)} = \mathbf{0},$          [set initial value of PA model]

$i = 0,$

**while** $NMSE \geq NMSE_{des}$ **do**      [iterate to desired accuracy]

$\qquad i = i + 1,$

$\qquad$ For all $M$ compute: $\tilde{\mathbf{a}}_{2m}^{(i)} = \widetilde{\boldsymbol{B}}_{2M}^{(i-1)} \lambda_m,$

$$\begin{bmatrix} \widetilde{\boldsymbol{\theta}}_1^{(i)} \\ \vdots \\ \widetilde{\boldsymbol{\theta}}_M^{(i)} \end{bmatrix} = \begin{bmatrix} \eta_{11}\mathbf{G}\left(\mathbf{a}_{11}, \tilde{\mathbf{a}}_{21}^{(i)}\right) & \cdots & \eta_{1M}\mathbf{G}\left(\mathbf{a}_{1M}, \tilde{\mathbf{a}}_{2M}^{(i)}\right) \\ \eta_{21}\mathbf{G}\left(\mathbf{a}_{11}, \tilde{\mathbf{a}}_{21}^{(i)}\right) & \cdots & \eta_{2M}\mathbf{G}\left(\mathbf{a}_{1M}, \tilde{\mathbf{a}}_{2M}^{(i)}\right) \end{bmatrix}^{\dagger} \begin{bmatrix} \mathbf{r}_1 \\ \mathbf{r}_2 \end{bmatrix},$$

$$\widetilde{\boldsymbol{B}}_{2M}^{(i)} = \begin{bmatrix} \mathbf{G}\left(\mathbf{a}_{11}, \tilde{\mathbf{a}}_{21}^{(i)}\right)\widetilde{\boldsymbol{\theta}}_1^{(i)} & \cdots & \mathbf{G}\left(\mathbf{a}_{1M}, \tilde{\mathbf{a}}_{2M}^{(i)}\right)\widetilde{\boldsymbol{\theta}}_M^{(i)} \end{bmatrix},$$

$$\begin{bmatrix} \tilde{\mathbf{r}}_1^{(i)} & \tilde{\mathbf{r}}_2^{(i)} \end{bmatrix} = \widetilde{\boldsymbol{B}}_{2M}^{(i)} \begin{bmatrix} \boldsymbol{\eta}_1 & \boldsymbol{\eta}_2 \end{bmatrix},$$

$$NMSE = \max_{l=1,2}\left\{ NMSE\left(\mathbf{r}_l, \tilde{\mathbf{r}}_l^{(i)}\right)\right\},$$

**end while**

$\boldsymbol{\theta}_m = \widetilde{\boldsymbol{\theta}}_m^{(i)}.$

If the reflection coefficients modeling the mutual coupling (e.g. due to cross talk and/or mismatch) are not known, they may be determined (i.e. estimated) using a recursive approach in which initial reflection coefficients are defined as an initial assumption. Such initial reflection coefficients may be selected using any suitable approach- For example, it may be initially assumed that there is no mutual coupling between the transmit antenna elements. Then, intermediate amplifying coefficients may be determined based on the initial reflection coefficients and intermediate reflection coefficients may be determined based on the intermediate amplifying coefficients, and so on until some stopping criterion is met (e.g. that the mean square error between subsequent recursions falls below a threshold value and/or that a maximum number of allowable recursions have been carried out).

An example of such a recursive approach for estimating the amplifier coefficients and the reflection coefficients can be illustrated by a pseudo-code function using three over-the-air measurements (i.e. three transmit observation receivers, $L = 3$) as follows, where $\mathbf{r}$ is a $3N \times 1$-dimensional vector, $[\cdot]^*$ denotes the complex conjugate, $P$ is the dimensionality of the polynomial model (indexed by $p$), and $\mathbf{f}_m^{(\cdot)}$ is a vector of $N$ samples from all the corresponding $f_m^{(\cdot)}$:

**known:**     input signals $a_{1m}$

channel coefficients $\eta_{1m}, \eta_{2m}, \eta_{3m}$

**measured:**   received signals $\mathbf{r} = [\mathbf{r}_1^T, \mathbf{r}_2^T, \mathbf{r}_3^T]^T$

$NMSE_{des} = X,$                    [define desired accuracy]

$NMSE = \infty,$

$\tilde{\boldsymbol{\lambda}}_m^{(0)} = \mathbf{1}, \tilde{\mathbf{a}}_{2m}^{(0)} = \mathbf{0}$                    [set initial values]

$i = 0,$

**while** $NMSE \geq NMSE_{des}$ **do**            [iterate to desired accuracy]

$i = i + 1,$

**STEP 1:**                    [find PA model coefficients]

$$\begin{bmatrix} \tilde{\boldsymbol{\theta}}_1^{(i)} \\ \vdots \\ \tilde{\boldsymbol{\theta}}_M^{(i)} \end{bmatrix} = \begin{bmatrix} \eta_{11}\mathbf{G}\left(\mathbf{a}_{11}, \tilde{\mathbf{a}}_{21}^{(i-1)}\right) & \dots & \eta_{1M}\mathbf{G}\left(\mathbf{a}_{1M}, \tilde{\mathbf{a}}_{2M}^{(i-1)}\right) \\ \eta_{21}\mathbf{G}\left(\mathbf{a}_{11}, \tilde{\mathbf{a}}_{21}^{(i-1)}\right) & \dots & \eta_{2M}\mathbf{G}\left(\mathbf{a}_{1M}, \tilde{\mathbf{a}}_{2M}^{(i-1)}\right) \\ \eta_{31}\mathbf{G}\left(\mathbf{a}_{11}, \tilde{\mathbf{a}}_{21}^{(i-1)}\right) & \dots & \eta_{3M}\mathbf{G}\left(\mathbf{a}_{1M}, \tilde{\mathbf{a}}_{2M}^{(i-1)}\right) \end{bmatrix}^{\dagger} \begin{bmatrix} \mathbf{r}_1 \\ \mathbf{r}_2 \\ \mathbf{r}_3 \end{bmatrix},$$

**if** $i > 1$ **then**

**STEP 2:**                    [find reflection coefficients]

$$f_m^{(0)} = \sum_{p=0}^{(P-1)/2} \tilde{\alpha}_{mp}^{(i)} \, a_{1m}^{p+1} {a_{1m}^*}^{p},$$

$$f_m^{(1)} = \sum_{p=0}^{(P-1)/2} \tilde{\beta}_{mp}^{(i)} \, a_{1m}^{p} {a_{1m}^*}^{p},$$

$$f_m^{(2)} = \sum_{p=0}^{(P-1)/2} \tilde{\gamma}_{mp}^{(i)} \, a_{1m}^{p+1} {a_{1m}^*}^{p-1},$$

$$\mathbf{F}_m^{(1)} = \mathrm{diag}\Big\{\mathbf{f}_m^{(1)}\Big\}\widetilde{\boldsymbol{B}}_{2M}^{(i-1)},$$

$$\mathbf{F}_m^{(2)} = \mathrm{diag}\Big\{\mathbf{f}_m^{(2)}\Big\}\widetilde{\boldsymbol{B}}_{2M}^{(i-1)*},$$

$$\mathbf{f}^{(0)} = \begin{bmatrix} \eta_{11}\mathbf{f}_1^{(0)} + \cdots + \eta_{1M}\mathbf{f}_M^{(0)} \\ \eta_{21}\mathbf{f}_1^{(0)} + \cdots + \eta_{2M}\mathbf{f}_M^{(0)} \\ \eta_{31}\mathbf{f}_1^{(0)} + \cdots + \eta_{3M}\mathbf{f}_M^{(0)} \end{bmatrix},$$

$$\mathbf{F}^{(1)} = \begin{bmatrix} \eta_{11}\mathbf{F}_1^{(1)} \cdots \eta_{1M}\mathbf{F}_M^{(1)} \\ \eta_{21}\mathbf{F}_1^{(1)} \cdots \eta_{2M}\mathbf{F}_M^{(1)} \\ \eta_{31}\mathbf{F}_1^{(1)} \cdots \eta_{3M}\mathbf{F}_M^{(1)} \end{bmatrix},$$

$$\mathbf{F}^{(2)} = \begin{bmatrix} \eta_{11}\mathbf{F}_1^{(2)} \cdots \eta_{1M}\mathbf{F}_M^{(2)} \\ \eta_{21}\mathbf{F}_1^{(2)} \cdots \eta_{2M}\mathbf{F}_M^{(2)} \\ \eta_{31}\mathbf{F}_1^{(2)} \cdots \eta_{3M}\mathbf{F}_M^{(2)} \end{bmatrix},$$

$$\begin{bmatrix} Re\{\widetilde{\boldsymbol{\lambda}}^{(1)}\} \\ Im\{\widetilde{\boldsymbol{\lambda}}^{(1)}\} \end{bmatrix} =$$

$$\begin{bmatrix} Re\{\mathbf{F}^{(1)} + \mathbf{F}^{(2)}\} & Im\{-\mathbf{F}^{(1)} + \mathbf{F}^{(2)}\} \\ Im\{\mathbf{F}^{(1)} + \mathbf{F}^{(2)}\} & Re\{\mathbf{F}^{(1)} - \mathbf{F}^{(2)}\} \end{bmatrix}^{\dagger} \begin{bmatrix} Re\{\boldsymbol{r} - \mathbf{f}^{(0)}\} \\ Im\{\boldsymbol{r} - \mathbf{f}^{(0)}\} \end{bmatrix},$$

$$[\text{where } \widetilde{\boldsymbol{\lambda}} = \big[\widetilde{\boldsymbol{\lambda}}_1^T, \widetilde{\boldsymbol{\lambda}}_2^T, \widetilde{\boldsymbol{\lambda}}_3^T\big]^T]$$

$$\widetilde{\lambda}_m^{(i)} = Re\Big\{\widetilde{\lambda}_m^{(i)}\Big\} + jIm\Big\{\widetilde{\lambda}_m^{(i)}\Big\},$$

$$\widetilde{\lambda}_m^{(i)} = \widetilde{\lambda}_m^{(i)} / \max_{q=1\ldots M; q\neq m} \widetilde{\lambda}_{mq}^{(i)}, \; \widetilde{\lambda}_{mm}^{(i)} = 1,$$

[normalization to avoid numerical problems]

$$\widetilde{\mathbf{a}}_{2m}^{(i)} = \widetilde{\boldsymbol{B}}_{2M}^{(i-1)}\widetilde{\lambda}_m^{(i)},$$

[calculate new estimate of reflection coefficients]

**end if**

$$\widetilde{\boldsymbol{B}}_{2M}^{(i)} = \Big[\mathbf{G}\Big(\mathbf{a}_{11}, \widetilde{\mathbf{a}}_{21}^{(i)}\Big)\widetilde{\boldsymbol{\theta}}_1^{(i)} \quad \ldots \quad \mathbf{G}\Big(\mathbf{a}_{1M}, \widetilde{\mathbf{a}}_{2M}^{(i)}\Big)\widetilde{\boldsymbol{\theta}}_M^{(i)}\Big],$$

[calculate new estimate of PA output signals]

$$\big[\widetilde{\mathbf{r}}_1^{(i)} \quad \widetilde{\mathbf{r}}_2^{(i)} \quad \widetilde{\mathbf{r}}_3^{(i)}\big] = \widetilde{\boldsymbol{B}}_{2m}^{(i)}[\boldsymbol{\eta}_1 \quad \boldsymbol{\eta}_2 \quad \boldsymbol{\eta}_3],$$

[calculate new estimate of received signals]

$$NMSE = \max_{l=1,2,3}\Big\{NMSE\Big(\mathbf{r}_l, \widetilde{\mathbf{r}}_l^{(i)}\Big)\Big\},$$

[evaluate accuracy]

## end while

Once the amplifier coefficients and the reflection coefficients are estimated or known, the model of the non-linear amplifier characteristics is complete and the digital pre-distortion parameters may be determined using any suitable approach. Examples of such approaches include the MILA (Model-based Indirect Learning Algorithm, described in P. Landin, A. Mayer, and T. Eriksson, "MILA - A Noise Mitigation Technique for RF Power Amplifier Linearization," in International Multi-Conference on Systems, Signals & Devices, Conference on Communication & Signal Processing, 2014) and other DLA (Direct Learning Algorithm) based methods (which may involve model inversion).

Typically, the amplifier coefficients and the reflection coefficients are updated at a similar (or the same) frequency as the pre-distortion parameters. Typically, the process of determining the pre-distortion parameters may be continuously performed in an iterative manner or they may be updated responsive to an triggering event (e.g. detection of that the channel has changed, regular time intervals, detection that the DPD does not fulfil some performance requirement, etc.).

Figure 4 illustrates an example method 400 according to some embodiments. The example method may, for example, be performed by a linearization device 380 or an arrangement 300 as described and exemplified in connection to Figure 3, and any features described in connection with Figure 3 may be equally applicable to the example method 400 according to various embodiments.

The example method 400 is for determining pre-distortion parameters associated with a plurality of non-linear amplifiers, each associated with a non-linear transfer function defining an output of the non-linear amplifier based on an input of the non-linear amplifier and based on a reflection signal for the non-linear amplifier, as described above.

In step 410, a plurality of channel coefficients are received (e.g. via a first port of the linearization device). The plurality of channel coefficients are indicative of channel characteristics of a plurality of communication paths between the plurality of non-linear amplifiers and two or more transmit observation receivers, wherein each transmit observation receiver is configured to receive a sum of transmission signals generated by the plurality of non-linear amplifiers and transferred over the communication paths between the plurality of non-linear amplifiers and the transmit observation receiver.

In step 420, the sums of transmission signals is received from the transmit observation receiver (e.g. via a second port of the linearization device).

In step 440, the pre-distortion parameters are determined based on the received plurality of channel coefficients, the received sums of transmission signals, and a model of the non-linear transfer functions of the non-linear amplifiers.

As described and exemplified above, the method may further comprise estimating the plurality of channel coefficients. Typically, a recursive procedure may be applied where intermediate amplifying coefficients are determined based on initially defined reflection coefficients, intermediate reflection coefficients are determined based on the intermediate amplifying coefficients, refined amplifying coefficients are determined recursively based on previous reflection coefficients, and refined reflection coefficients are determined recursively based on previous amplifying coefficients. Such recursion may, for example, continue a predefined number of times and/or until some stopping criterion is met.

The described embodiments and their equivalents may be realized in software or hardware or a combination thereof. The embodiments may be performed by general purpose circuitry. Examples of general purpose circuitry include digital signal processors (DSP), central processing units (CPU), co-processor units, field programmable gate arrays (FPGA) and other programmable hardware. Alternatively or additionally, the embodiments may be performed by specialized circuitry, such as application specific integrated circuits (ASIC). The general purpose circuitry and/or the specialized circuitry may, for example, be associated with or comprised in an apparatus such as a wireless transmitter node (e.g. a network node) or a cloud based server node.

Embodiments may appear within an electronic apparatus (such as a wireless transmitter node or a cloud based server node) comprising arrangements, circuitry, and/or logic according to any of the embodiments described herein. Alternatively or additionally, an electronic apparatus (such as a wireless transmitter node or a cloud based server node) may be configured to perform methods according to any of the embodiments described herein.

According to some embodiments, a computer program product comprises a computer readable medium such as, for example a universal serial bus (USB) memory, a plug-in card, an embedded drive or a read only memory (ROM). Figure 5 illustrates an example computer readable medium in the form of a compact disc (CD) ROM 500. The computer readable medium has stored thereon a computer program comprising program instructions. The computer program is loadable into a data processor (PROC) 520, which may, for example, be comprised in a wireless transmitter node or a cloud based server node. When loaded into the data processing unit, the computer program may be stored in a memory (MEM) 530 associated with or comprised in the data-processing unit. According to some embodiments, the computer program may, when loaded into and run by the data processing unit, cause execution of method steps according to, for example, the method illustrated in Figure 4 or otherwise described herein.

Generally, all terms used herein are to be interpreted according to their ordinary meaning in the relevant technical field, unless a different meaning is clearly given and/or is implied from the context in which it is used.

Reference has been made herein to various embodiments. However, a person skilled in the art would recognize numerous variations to the described embodiments that would still fall within the scope of the claims.

For example, the method embodiments described herein discloses example methods through steps being performed in a certain order. However, it is recognized that these sequences of events may take place in another order without departing from the scope of the claims. Furthermore, some method steps may be performed in parallel even though they have been described as being performed in sequence. Thus, the steps of any methods disclosed herein do not have to be performed in the exact order disclosed, unless a step is explicitly described as following or preceding another step and/or where it is implicit that a step must follow or precede another step.

In the same manner, it should be noted that in the description of embodiments, the partition of functional blocks into particular units is by no means intended as limiting. Contrarily, these partitions are merely examples. Functional blocks described herein as one unit may be split into two or more units. Furthermore, functional blocks described herein as being implemented as two or more units may be merged into fewer (e.g. a single) unit.

Any feature of any of the embodiments disclosed herein may be applied to any other embodiment, wherever suitable. Likewise, any advantage of any of the embodiments may apply to any other embodiments, and vice versa.

Hence, it should be understood that the details of the described embodiments are merely examples brought forward for illustrative purposes, and that all variations that fall within the scope of the claims are intended to be embraced therein.

## Claims

1.  A linearization device (380) configured to determine pre-distortion parameters associated with a plurality of non-linear amplifiers (331, 332, 333, 334), each associated with a respective one of a plurality of transmit antenna elements (341, 342, 343, 344) and with a non-linear transfer function defining an output of the non-linear amplifier based on an input of the non-linear amplifier and based on a reflection signal for the non-linear amplifier, resulting from mutual couplings among the plurality of transmit antenna elements, the linearization device comprising:

    a first port (381) configured to receive a plurality of channel coefficients indicative of channel characteristics of a plurality of communication paths (391, 392, 393, 394) between the plurality of non-linear amplifiers and two or more transmit observation receivers (370, 371, 372), wherein each transmit observation receiver (370, 371, 372) is configured to receive a sum of transmission signals generated by the plurality of non-linear amplifiers and transferred over the communication paths between the plurality of non-linear amplifiers and the transmit observation receiver;

    a second port (382) configured to receive the sums of transmission signals from the transmit observation receivers (370, 371, 372); and

    determination circuitry (383) configured to determine the pre-distortion parameters based on the received plurality of channel coefficients, the received sums of transmission signals, and a model of the non-linear transfer functions of the non-linear amplifiers (331, 332, 333, 334), wherein the pre-distortion parameters are for compensation of the non-linear transfer functions of the plurality of non-linear amplifiers.

2.  The linearization device of claim 1, wherein the model is represented, for each of the non-linear amplifiers, by a plurality of amplifying coefficients in a space spanned by a regression matrix of the inputs and the reflection signals.

3.  The linearization device of claim 2, wherein each reflection signal is modelled as a linear function of the outputs of the plurality of non-linear amplifiers, the linear function being defined by reflection coefficients.

4.  The linearization device of claim 3, wherein the two or more transmit observation receivers comprise three or more transmit observation receivers, and wherein the determination circuitry is further configured to determine the reflection coefficients by:

    defining initial reflection coefficients;
    determining intermediate amplifying coefficients based on the initial reflection coefficients;
    determining intermediate reflection coefficients based on the intermediate amplifying coefficients; and
    recursively determining refined amplifying coefficients based on previous reflection coefficients, and refined reflection coefficients based on previous amplifying coefficients.

5.  The linearization device of any of claims 2 through 4, wherein the linearization device is configured to determine the pre-distortion parameters based on the amplifying coefficients.

6. The linearization device of claim 5, wherein the linearization device is configured to determine the amplifying coefficients based on $N$ samples of the sums of transmission signals received by the transmit observation receivers via $L$ receive antenna ports (355, 356, 357) by:

determining, for each of the plurality of non-linear amplifiers, a Kronecker product between a column vector having as elements the corresponding estimated channel coefficients and the regression matrix;
calculating a generalized pseudo-inverse of a matrix formed by concatenating the determined Kronecker products of the plurality of non-linear amplifiers; and
determining a matrix product between the calculated generalized pseudo-inverse and a column vector having as elements the $N$ samples of the sums of transmission signals from each of the $L$ receive antenna ports.

7. An arrangement for a wireless transmitter node, the wireless transmitter node comprising at least two receive antenna ports (355, 356, 357), each connectable to a corresponding receive antenna element (350, 351, 352), and a plurality of transmit antenna ports (345, 346, 347, 348), each connectable to a corresponding transmit antenna element of an active antenna array having a plurality of transmit antenna elements (341, 342, 343, 344), each transmit antenna port being associated with a respective transmitter branch, wherein each transmitter branch comprises:

- a non-linear amplifier (331, 332, 333, 334) associated with a respective one of the plurality of transmit antenna elements and with a non-linear transfer function defining an output of the non-linear amplifier based on an input of the non-linear amplifier and based on a reflection signal for the non-linear amplifier, resulting from mutual couplings among the plurality of transmit antenna elements; and
- digital pre-distortion circuitry (321, 322, 323, 324) configured to compensate the non-linear transfer function by pre-distorting the signal of the transmitter branch based on pre-distortion parameters;

the arrangement comprising:

- a channel estimator (360) configured to estimate a plurality of channel coefficients indicative of channel characteristics of a plurality of communication paths (391, 392, 393, 394) between the plurality of non-linear amplifiers and two or more transmit observation receivers;
- the two or more transmit observation receivers (370, 371, 372), each associated with one of the at least two receive antenna ports and each configured to receive a sum of transmission signals generated by the plurality of non-linear amplifiers and transferred over the communication paths (391, 392, 393, 394) between the plurality of non-linear amplifiers and the transmit observation receiver; and
- the linearization device (380) of any of claims 1 through 7, wherein the first port is connected to the channel estimator and the second port is connected to the transmit observation receiver and wherein the linearization device is configured to provide the determined pre-distortion parameters to the digital pre-distortion circuitry of the transmitter branches.

8. The arrangement of claim 7 further comprising the at least two receive antenna ports and the at least two receive antenna elements.

9. A wireless transmitter node comprising at least one of the linearization device of any of claims 1 through 6 and the arrangement of any of claims 7 through 8.

10. A cloud based server node comprising the linearization device of any of claims 1 through 6, wherein the cloud based server node is configured to provide the determined pre-distortion parameters to a wireless transmitter node.

11. A method for a linearization device for determining pre-distortion parameters associated with a plurality of non-linear amplifiers (331, 332, 333, 334), each associated with a respective one of a plurality of transmit antenna elements (341, 342, 343, 344) and with a non-linear transfer function defining an output of the non-linear amplifier based on an input of the non-linear amplifier and based on a reflection signal for the non-linear amplifier, resulting from mutual couplings among the plurality of transmit antenna elements, the method comprising:

receiving (410), via a first port (381) of the linearization device, a plurality of channel coefficients indicative of channel characteristics of a plurality of communication paths (391, 392, 393, 394) between the plurality of non-linear amplifiers and two or more transmit observation receivers (370, 371, 372), wherein each transmit observation receiver (370, 371, 372) is configured to receive a sum of transmission signals generated by the plurality of non-linear amplifiers and transferred over the communication paths between the plurality of non-linear amplifiers and the transmit observation receiver;

receiving (420), via a second port (382) of the linearization device, the sums of transmission signals from the transmit observation receiver (370, 371, 372); and

determining (440) the pre-distortion parameters based on the received plurality of channel coefficients, the received sums of transmission signals, and a model of the non-linear transfer functions of the non-linear amplifiers (331, 332, 333, 334), wherein the pre-distortion parameters are for compensation of the non-linear transfer functions of the plurality of non-linear amplifiers.

12. The method of claim 11 wherein the model is represented, for each of the non-linear amplifiers, by a plurality of amplifying coefficients in a space spanned by a regression matrix of the inputs and the reflection signals.

13. The method of claim 12, wherein each reflection signal is modelled as a linear function of the outputs of the plurality of non-linear amplifiers, the linear function being defined by reflection coefficients.

14. The method of claim 13, wherein the two or more transmit observation receivers comprise three or more transmit observation receivers, and wherein the method further comprises determining the reflection coefficients by:

defining initial reflection coefficients;

determining intermediate amplifying coefficients based on the initial reflection coefficients;

determining intermediate reflection coefficients based on the intermediate amplifying coefficients; and

recursively determining refined amplifying coefficients based on previous reflection coefficients, and refined reflection coefficients based on previous amplifying coefficients.

15. The method of any of claims 12 through 14, wherein the pre-distortion parameters are determined based on the amplifying coefficients.

16. The method of claim 15 wherein determining the amplifying coefficients based on $N$ samples of the sums of transmission signals received by the transmit observation receiver via L receive antenna ports (355, 356, 357) comprises:

determining, for each of the plurality of non-linear amplifiers, a Kronecker product between a column vector having as elements the corresponding estimated channel coefficients and the regression matrix;

calculating a generalized pseudo-inverse of a matrix formed by concatenating the determined Kronecker products of the plurality of non-linear amplifiers; and

determining a matrix product between the calculated generalized pseudo-inverse and a column vector having as elements the N samples of the sums of transmission signals from each of the L receive antenna ports.

17. A computer program product comprising a non-transitory computer readable medium, having thereon a computer program comprising program instructions, the computer program being loadable into a data processing unit and configured to cause execution of the method according to any of claims 11 through 16 when the computer program is run by the data processing unit.

**Patentansprüche**

1. Linearisierungsvorrichtung (380), die dazu ausgelegt ist, Vorverzerrungsparameter zu bestimmen, die mit einer Mehrzahl von nichtlinearen Verstärkern (331, 332, 333, 334), die jeweils mit einem jeweiligen einer Mehrzahl von Sendeantennenelementen (341, 342, 343, 344) assoziiert sind, und mit einer nichtlinearen Übertragungsfunktion assoziiert sind, die eine Ausgabe des nichtlinearen Verstärkers basierend auf einer Eingabe des nichtlinearen Verstärkers und basierend auf einem Reflexionssignal für den nichtlinearen Verstärker definiert, das aus gegenseitigen Kopplungen zwischen der Mehrzahl von Sendeantennenelementen resultiert, wobei die Linearisierungsvorrichtung Folgendes umfasst:

einen ersten Anschluss (381), der dazu ausgelegt ist, eine Mehrzahl von Kanalkoeffizienten zu empfangen, die Kanalcharakteristiken einer Mehrzahl von Kommunikationspfaden (391, 392, 393, 394) zwischen der Mehrzahl von nichtlinearen Verstärkern und zwei oder mehr Sendebeobachtungsempfängern (370, 371, 372) anzeigt, wobei jeder Sendebeobachtungsempfänger (370, 371, 372) dazu ausgelegt ist, eine Summe von Übertragungssignalen zu empfangen, die von der Mehrzahl von nichtlinearen Verstärkern erzeugt und über die Kommunikationspfade zwischen der Mehrzahl von nichtlinearen Verstärkern und den Sendebeobachtungsempfängern übertragen wird;

einen zweiten Anschluss (382), der dazu ausgelegt ist, die Summen von Übertragungssignalen von den Sendebeobachtungsempfängern (370, 371, 372) zu empfangen; und

Bestimmungsschaltungsanordnung (383), die dazu ausgelegt ist, die Vorverzerrungsparameter basierend auf der empfangenen Mehrzahl von Kanalkoeffizienten, den empfangenen Summen von Übertragungssignalen und einem Modell der nichtlinearen Übertragungsfunktionen der nichtlinearen Verstärker (331, 332, 333, 334) zu bestimmen, wobei die Vorverzerrungsparameter zur Kompensation der nichtlinearen Übertragungsfunktionen der Mehrzahl von nichtlinearen Verstärkern sind.

2. Linearisierungsvorrichtung nach Anspruch 1, wobei das Modell für jeden der nichtlinearen Verstärker durch eine Mehrzahl von Verstärkungskoeffizienten in einem Raum dargestellt wird, der von einer Regressionsmatrix der Eingaben und der Reflexionssignale umspannt wird.

3. Linearisierungsvorrichtung nach Anspruch 2, wobei jedes Reflexionssignal als eine lineare Funktion der Ausgaben der Mehrzahl von nichtlinearen Verstärker modelliert wird, wobei die lineare Funktion durch Reflexionskoeffizienten definiert wird.

4. Linearisierungsvorrichtung nach Anspruch 3, wobei der eine oder die mehreren Sendebeobachtungsempfänger drei oder mehr Sendebeobachtungsempfänger umfassen und wobei die Bestimmungsschaltungsanordnung ferner dazu ausgelegt ist, die Reflexionskoeffizienten durch Folgendes zu bestimmen:

Definieren anfänglicher Reflexionskoeffizienten;
Bestimmen von Zwischenverstärkungskoeffizienten basierend auf den anfänglichen Reflexionskoeffizienten;
Bestimmen von Zwischenreflexionskoeffizienten basierend auf den Zwischenverstärkungskoeffizienten; und
rekursives Bestimmen verfeinerter Verstärkungskoeffizienten basierend auf vorherigen Reflexionskoeffizienten und verfeinerter Reflexionskoeffizienten basierend auf vorherigen Verstärkungskoeffizienten.

5. Linearisierungsvorrichtung nach einem der Ansprüche 2 bis 4, wobei die Linearisierungsvorrichtung dazu ausgelegt ist, die Vorverzerrungsparameter basierend auf den Verstärkungskoeffizienten zu bestimmen.

6. Linearisierungsvorrichtung nach Anspruch 5, wobei die Linearisierungsvorrichtung dazu ausgelegt ist, die Verstärkungskoeffizienten basierend auf N Abtastwerten der durch die Sendebeobachtungsempfänger über L Empfangsantennenanschlüsse (355, 356, 357) empfangenen Summen von Übertragungssignalen durch Folgendes zu bestimmen:

Bestimmen eines Kronecker-Produkts zwischen einem Spaltenvektor, der als Elemente die entsprechenden geschätzten Kanalkoeffizienten aufweist, und der Regressionsmatrix für jeden der Mehrzahl von nichtlinearen Verstärkern;
Berechnen einer verallgemeinerten Pseudoinversen einer Matrix, die durch Verketten der bestimmten Kronecker-Produkte der Mehrzahl von nichtlinearen Verstärker gebildet wird; und
Bestimmen eines Matrixprodukts zwischen der berechneten verallgemeinerten Pseudoinversen und einem Spaltenvektor, der als Elemente die N Abtastwerte der Summen von Übertragungssignalen von jedem der L Empfangsantennenanschlüsse aufweist.

7. Anordnung für einen drahtlosen Senderknoten, wobei der drahtlose Senderknoten mindestens zwei Empfangsantennenanschlüsse (355, 356, 357), die jeweils mit einem entsprechenden Empfangsantennenelement (350, 351, 352) verbunden werden können, und eine Mehrzahl von Sendeantennenschlüssen (345, 346, 347, 348) umfasst, die jeweils mit einem entsprechenden Sendeantennenelement einer aktiven Antennengruppe mit einer Mehrzahl von Sendeantennenelementen (341, 342, 343, 344) verbunden werden können, wobei jeder Sendeantennenanschluss mit einem jeweiligen Senderzweig assoziiert ist, wobei jeder Senderzweig Folgendes umfasst:

- einen nichtlinearen Verstärker (331, 332, 333, 334), der mit einem jeweiligen der Mehrzahl von Sendeantennenelementen und mit einer nichtlinearen Übertragungsfunktion assoziiert sind, die eine Ausgabe des nichtlinearen Verstärkers basierend auf einer Eingabe des nichtlinearen Verstärkers und basierend auf einem Reflexionssignal für den nichtlinearen Verstärker definiert, das aus gegenseitigen Kopplungen zwischen der Mehrzahl von Sendeantennenelementen resultiert; und
- eine digitale Vorverzerrungsschaltungsanordnung (321, 322, 323, 324), die dazu ausgelegt ist, die nichtlineare Übertragungsfunktion durch Vorverzerren des Signals des Senderzweigs basierend auf Vorverzerrungsparametern zu kompensieren;

wobei die Anordnung Folgendes umfasst:

- einen Kanalschätzer (360), der dazu ausgelegt ist, eine Mehrzahl von Kanalkoeffizienten zu schätzen, die Kanalcharakteristiken einer Mehrzahl von Kommunikationspfaden (391, 392, 393, 394) zwischen der Mehrzahl von nichtlinearen Verstärkern und zwei oder mehr Sendebeobachtungsempfängern anzeigt;
- die zwei oder mehr Sendebeobachtungsempfänger (370, 371, 372), die jeweils mit einem der mindestens zwei Empfangsantennenanschlüsse assoziiert und jeweils dazu ausgelegt sind, eine Summe von Übertragungssignalen zu empfangen, die von der Mehrzahl von nichtlinearen Verstärkern erzeugt und über die Kommunikationspfade (391, 392, 393, 394) zwischen der Mehrzahl von nichtlinearen Verstärkern und den Sendebeobachtungsempfängern übertragen wird; und
- die Linearisierungsvorrichtung (380) nach einem der Ansprüche 1 bis 7, wobei der erste Anschluss mit dem Kanalschätzer verbunden ist und der zweite Anschluss mit dem Sendebeobachtungsempfänger verbunden ist und wobei die Linearisierungsvorrichtung dazu ausgelegt ist, die bestimmten Vorverzerrungsparameter der digitalen Vorverzerrungsschaltungsanordnung der Senderzweige bereitzustellen.

8. Anordnung nach Anspruch 7, ferner umfassend die mindestens zwei Sendeantennenanschlüsse und die mindestens zwei Empfangsantennenanschlüsse.

9. Drahtloser Senderknoten, umfassend mindestens eine von der Linearisierungsvorrichtung nach einem Ansprüche 1 bis 6 und der Anordnung nach einem der Ansprüche 7 bis 8.

10. Cloud-basierter Serverknoten, umfassend die Linearisierungsvorrichtung nach einem Ansprüche 1 bis 6, wobei der Cloud-basierte Serverknoten dazu ausgelegt ist, die bestimmten Vorverzerrungsparameter einem drahtlosen Senderknoten bereitzustellen.

11. Verfahren für eine Linearisierungsvorrichtung zum Bestimmen von Vorverzerrungsparametern, die mit einer Mehrzahl von nichtlinearen Verstärkern (331, 332, 333, 334), die jeweils mit einem jeweiligen einer Mehrzahl von Sendeantennenelementen (341, 342, 343, 344) assoziiert sind, und mit einer nichtlinearen Übertragungsfunktion assoziiert sind, die eine Ausgabe des nichtlinearen Verstärkers basierend auf einer Eingabe des nichtlinearen Verstärkers und basierend auf einem Reflexionssignal für den nichtlinearen Verstärker definiert, das aus gegenseitigen Kopplungen zwischen der Mehrzahl von Sendeantennenelementen resultiert, wobei das Verfahren Folgendes umfasst:

Empfangen (410) einer Mehrzahl von Kanalkoeffizienten, die Kanalcharakteristiken einer Mehrzahl von Kommunikationspfaden (391, 392, 393, 394) zwischen der Mehrzahl von nichtlinearen Verstärkern und zwei oder mehr Sendebeobachtungsempfängern (370, 371, 372) anzeigt, über einen ersten Anschluss (381) der Linearisierungsvorrichtung, wobei jeder Sendebeobachtungsempfänger (370, 371, 372) dazu ausgelegt ist, eine Summe von Übertragungssignalen zu empfangen, die von der Mehrzahl von nichtlinearen Verstärkern erzeugt und über die Kommunikationspfade zwischen der Mehrzahl von nichtlinearen Verstärkern und den Sendebeobachtungsempfängern übertragen wird;
Empfangen (420) der Summen von Übertragungssignalen von den Sendebeobachtungsempfängern (370, 371, 372) über einen zweiten Anschluss (382) der Linearisierungsvorrichtung; und
Bestimmen (440) der Vorverzerrungsparameter basierend auf der empfangenen Mehrzahl von Kanalkoeffizienten, den empfangenen Summen von Übertragungssignalen und einem Modell der nichtlinearen Übertragungsfunktionen der nichtlinearen Verstärker (331, 332, 333, 334), wobei die Vorverzerrungsparameter zur Kompensation der nichtlinearen Übertragungsfunktionen der Mehrzahl von nichtlinearen Verstärkern sind.

12. Verfahren nach Anspruch 11, wobei das Modell für jeden der nichtlinearen Verstärker durch eine Mehrzahl von Verstärkungskoeffizienten in einem Raum dargestellt wird, der von einer Regressionsmatrix der Eingaben und der Reflexionssignale umspannt wird.

13. Verfahren nach Anspruch 12, wobei jedes Reflexionssignal als eine lineare Funktion der Ausgaben der Mehrzahl von nichtlinearen Verstärker modelliert wird, wobei die lineare Funktion durch Reflexionskoeffizienten definiert wird.

14. Verfahren nach Anspruch 13, wobei die zwei oder mehr Sendebeobachtungsempfänger drei oder mehr Sendebeobachtungsempfänger umfassen und wobei das Verfahren ferner Bestimmen des Reflexionskoeffizienten durch Folgendes umfasst:

> Definieren anfänglicher Reflexionskoeffizienten;
> Bestimmen von Zwischenverstärkungskoeffizienten basierend auf den anfänglichen Reflexionskoeffizienten;
> Bestimmen von Zwischenreflexionskoeffizienten basierend auf den Zwischenverstärkungskoeffizienten; und
> rekursives Bestimmen verfeinerter Verstärkungskoeffizienten basierend auf vorherigen Reflexionskoeffizienten und verfeinerter Reflexionskoeffizienten basierend auf vorherigen Verstärkungskoeffizienten.

15. Verfahren nach einem der Ansprüche 12 bis 14, wobei die Vorverzerrungsparameter basierend auf den Verstärkungskoeffizienten bestimmt werden.

16. Verfahren nach Anspruch 15, wobei das Bestimmen der Verstärkungskoeffizienten basierend auf N Abtastwerten der durch den Sendebeobachtungsempfänger über $L$ Empfangsantennenanschlüsse (355, 356, 357) empfangenen Summen von Übertragungssignalen Folgendes umfasst:

> Bestimmen eines Kronecker-Produkts zwischen einem Spaltenvektor, der als Elemente die entsprechenden geschätzten Kanalkoeffizienten aufweist, und der Regressionsmatrix für jeden der Mehrzahl von nichtlinearen Verstärkern;
> Berechnen einer verallgemeinerten Pseudoinversen einer Matrix, die durch Verketten der bestimmten Kronecker-Produkte der Mehrzahl von nichtlinearen Verstärker gebildet wird; und
> Bestimmen eines Matrixprodukts zwischen der berechneten verallgemeinerten Pseudoinversen und einem Spaltenvektor, der als Elemente die N Abtastwerte der Summen von Übertragungssignalen von jedem der L Empfangsantennenanschlüsse aufweist.

17. Computerprogrammprodukt, umfassend ein nichtflüchtiges computerlesbares Medium, das ein Computerprogramm darauf aufweist, das Programmbefehle umfasst, wobei das Computerprogramm in eine Datenverarbeitungseinheit geladen werden kann und so ausgelegt ist, dass es die Ausführung des Verfahrens nach einem der Ansprüche 11 bis 16 bewirkt, wenn das Computerprogramm von der Datenverarbeitungseinheit ausgeführt wird.

## Revendications

1. Dispositif de linéarisation (380) configuré pour déterminer des paramètres de prédistorsion associés à une pluralité d'amplificateurs non linéaires (331, 332, 333, 334), chacun d'eux étant associé à l'un respectif d'une pluralité d'éléments d'antenne de transmission (341, 342, 343, 344) et à une fonction de transfert non linéaire définissant une sortie de l'amplificateur non linéaire sur la base d'une entrée de l'amplificateur non linéaire et sur la base d'un signal de réflexion pour l'amplificateur non linéaire, découlant de couplages mutuels parmi la pluralité d'éléments d'antenne de transmission, le dispositif de linéarisation comprenant :

> un premier port (381) configuré pour recevoir une pluralité de coefficients de canal indiquant des caractéristiques de canal d'une pluralité de voies de communication (391, 392, 393, 394) entre la pluralité d'amplificateurs non linéaires et deux récepteurs d'observation de transmission (370, 371, 372) ou plus, dans lequel chaque récepteur d'observation de transmission (370, 371, 372) est configuré pour recevoir une somme de signaux de transmission générés par la pluralité d'amplificateurs non linéaires et transférés sur les voies de communication entre la pluralité d'amplificateurs non linéaires et le récepteur d'observation de transmission ;
> un deuxième port (382) configuré pour recevoir les sommes de signaux de transmission depuis les récepteurs d'observation de transmission (370, 371, 372) ; et
> une circuiterie de détermination (383) configurée pour déterminer les paramètres de prédistorsion sur la base de la pluralité reçue de coefficients de canal, des sommes reçues de signaux de transmission, et d'un modèle des fonctions de transfert non linéaires des amplificateurs non linéaires (331, 332, 333, 334), dans lequel les paramètres de prédistorsion sont destinés à une compensation des fonctions de transfert non linéaires de la pluralité d'amplificateurs non linéaires.

2. Dispositif de linéarisation selon la revendication 1, dans lequel le modèle est représenté, pour chacun des amplificateurs non linéaires, par une pluralité de coefficients d'amplification dans un espace couvert par une matrice de régression des entrées et des signaux de réflexion.

**3.** Dispositif de linéarisation selon la revendication 2, dans lequel chaque signal de réflexion est modélisé en tant que fonction linéaire des sorties de la pluralité d'amplificateurs non linéaires, la fonction linéaire étant définie par des coefficients de réflexion.

**4.** Dispositif de linéarisation selon la revendication 3, dans lequel les deux récepteurs d'observation de transmission ou plus comprennent trois récepteurs d'observation de transmission ou plus, et dans lequel la circuiterie de détermination est en outre configurée pour déterminer les coefficients de réflexion par :

la définition de coefficients de réflexion initiaux ;
la détermination de coefficients d'amplification intermédiaires sur la base des coefficients de réflexion initiaux ;
la détermination de coefficients de réflexion intermédiaires sur la base des coefficients d'amplification intermédiaires ; et
la détermination récursive de coefficients d'amplification affinés sur la base de coefficients de réflexion précédents, et de coefficients de réflexion affinés sur la base de coefficients d'amplification précédents.

**5.** Dispositif de linéarisation selon l'une quelconque des revendications 2 à 4, dans lequel le dispositif de linéarisation est configuré pour déterminer les paramètres de prédistorsion sur la base des coefficients d'amplification.

**6.** Dispositif de linéarisation selon la revendication 5, dans lequel le dispositif de linéarisation est configuré pour déterminer les coefficients d'amplification sur la base de $N$ échantillons des sommes de signaux de transmission reçus par les récepteurs d'observation de transmission via $L$ ports d'antenne de réception (355, 356, 357) par :

la détermination, pour chacun de la pluralité d'amplificateurs non linéaires, d'un produit de Kronecker entre un vecteur de colonne ayant comme éléments les coefficients de canal estimés correspondants et la matrice de régression ;
le calcul d'un pseudo-inverse généralisé d'une matrice formée par concaténation des produits de Kronecker déterminés de la pluralité d'amplificateurs non linéaires ; et
la détermination d'un produit matriciel entre le pseudo-inverse généralisé calculé et un vecteur de colonne ayant comme éléments les $N$ échantillons des sommes de signaux de transmission provenant de chacun des L ports d'antenne de réception.

**7.** Agencement pour un nœud émetteur sans fil, le nœud émetteur sans fil comprenant au moins deux ports d'antenne de réception (355, 356, 357), chacun d'eux pouvant être relié à un élément d'antenne de réception (350, 351, 352) correspondant, et une pluralité de ports d'antenne de transmission (345, 346, 347, 348), chacun d'eux pouvant être relié à un élément d'antenne de transmission correspondant d'un réseau d'antennes actives ayant une pluralité d'éléments d'antenne de transmission (341, 342, 343, 344), chaque port d'antenne de transmission étant associé à une branche de transmission respective, dans lequel chaque branche de transmission comprend :

- un amplificateur non linéaire (331, 332, 333, 334) associé à l'un respectif de la pluralité d'éléments d'antenne de transmission et à une fonction de transfert non linéaire définissant une sortie de l'amplificateur non linéaire sur la base d'une entrée de l'amplificateur non linéaire et sur la base d'un signal de réflexion pour l'amplificateur non linéaire, découlant de couplages mutuels parmi la pluralité d'éléments d'antenne de transmission ; et
- une circuiterie de prédistorsion numérique (321, 322, 323, 324) configurée pour compenser la fonction de transfert non linéaire par la prédistorsion du signal de la branche de transmission sur la base des paramètres de prédistorsion ;

l'agencement comprenant :

- un estimateur de canal (360) configuré pour estimer une pluralité de coefficients de canal indiquant des caractéristiques de canal d'une pluralité de voies de communication (391, 392, 393, 394) entre la pluralité d'amplificateurs non linéaires et deux récepteurs d'observation de transmission ou plus ;
- les deux récepteurs d'observation de transmission (370, 371, 372) ou plus étant chacun associés à l'un des au moins deux ports d'antenne de réception et étant chacun configurés pour recevoir une somme de signaux de transmission générés par la pluralité d'amplificateurs non linéaires et transférés sur les voies de communication (391, 392, 393, 394) entre la pluralité d'amplificateurs non linéaires et le récepteur d'observation de transmission ; et
- le dispositif de linéarisation (380) selon l'une quelconque des revendications 1 à 7, dans lequel le premier port est relié à l'estimateur de canal et le deuxième port est relié au récepteur d'observation de transmission, et dans lequel le dispositif de linéarisation est configuré pour fournir les paramètres de prédistorsion déterminés à la circuiterie de prédistorsion numérique des branches de transmission.

8. Agencement selon la revendication 7, comprenant en outre les au moins deux ports d'antenne de réception et les au moins deux éléments d'antenne de réception.

9. Nœud émetteur sans fil comprenant au moins l'un du dispositif de linéarisation selon l'une quelconque des revendications 1 à 6 et de l'agencement selon l'une quelconque des revendications 7 et 8.

10. Nœud serveur basé sur le cloud comprenant le dispositif de linéarisation selon l'une quelconque des revendications 1 à 6, dans lequel le nœud serveur basé sur le cloud est configuré pour fournir les paramètres de prédistorsion déterminés à un nœud émetteur sans fil.

11. Procédé permettant à un dispositif de linéarisation de déterminer des paramètres de prédistorsion associés à une pluralité d'amplificateurs non linéaires (331, 332, 333, 334), chacun d'eux étant associé à l'un respectif d'une pluralité d'éléments d'antenne de transmission (341, 342, 343, 344) et à une fonction de transfert non linéaire définissant une sortie de l'amplificateur non linéaire sur la base d'une entrée de l'amplificateur non linéaire et sur la base d'un signal de réflexion pour l'amplificateur non linéaire, découlant de couplages mutuels parmi la pluralité d'éléments d'antenne de transmission, le procédé comprenant :

la réception (410), via un premier port (381) du dispositif de linéarisation, d'une pluralité de coefficients de canal indiquant des caractéristiques de canal d'une pluralité de voies de communication (391, 392, 393, 394) entre la pluralité d'amplificateurs non linéaires et deux récepteurs d'observation de transmission (370, 371, 372) ou plus, dans lequel chaque récepteur d'observation de transmission (370, 371, 372) est configuré pour recevoir une somme de signaux de transmission générés par la pluralité d'amplificateurs non linéaires et transférés sur les voies de communication entre la pluralité d'amplificateurs non linéaires et le récepteur d'observation de transmission ;
la réception (420), via un deuxième port (382) du dispositif de linéarisation, des sommes de signaux de transmission depuis les récepteurs d'observation de transmission (370, 371, 372) ; et
la détermination (440) des paramètres de prédistorsion sur la base de la pluralité reçue de coefficients de canal, des sommes reçues de signaux de transmission, et d'un modèle des fonctions de transfert non linéaires des amplificateurs non linéaires (331, 332, 333, 334), dans lequel les paramètres de prédistorsion sont destinés à une compensation des fonctions de transfert non linéaires de la pluralité d'amplificateurs non linéaires.

12. Procédé selon la revendication 11, dans lequel le modèle est représenté, pour chacun des amplificateurs non linéaires, par une pluralité de coefficients d'amplification dans un espace couvert par une matrice de régression des entrées et des signaux de réflexion.

13. Procédé selon la revendication 12, dans lequel chaque signal de réflexion est modélisé en tant que fonction linéaire des sorties de la pluralité d'amplificateurs non linéaires, la fonction linéaire étant définie par des coefficients de réflexion.

14. Procédé selon la revendication 13, dans lequel les deux récepteurs d'observation de transmission ou plus comprennent trois récepteurs d'observation de transmission ou plus, et dans lequel le procédé comprend en outre la détermination des coefficients de réflexion par :

la définition de coefficients de réflexion initiaux ;
la détermination de coefficients d'amplification intermédiaires sur la base des coefficients de réflexion initiaux ;
la détermination de coefficients de réflexion intermédiaires sur la base des coefficients d'amplification intermédiaires ; et
la détermination récursive de coefficients d'amplification affinés sur la base de coefficients de réflexion précédents, et de coefficients de réflexion affinés sur la base de coefficients d'amplification précédents.

15. Procédé selon l'une quelconque des revendications 12 à 14, dans lequel les paramètres de prédistorsion sont déterminées sur la base des coefficients d'amplification.

16. Procédé selon la revendication 15, dans lequel la détermination des coefficients d'amplification sur la base de $N$ échantillons des sommes de signaux de transmission reçus par le récepteur d'observation de transmission via $L$ ports d'antenne de réception (355, 356, 357) comprend :

la détermination, pour chacun de la pluralité d'amplificateurs non linéaires, d'un produit de Kronecker entre un vecteur de colonne ayant comme éléments les coefficients de canal estimés correspondants et la matrice de régression ;

le calcul d'un pseudo-inverse généralisé d'une matrice formée par concaténation des produits de Kronecker déterminés de la pluralité d'amplificateurs non linéaires ; et

la détermination d'un produit matriciel entre le pseudo-inverse généralisé calculé et un vecteur de colonne ayant comme éléments les N échantillons des sommes de signaux de transmission provenant de chacun des *L* ports d'antenne de réception.

17. Produit programme informatique comprenant un support non transitoire lisible par ordinateur sur lequel est stocké un programme informatique comprenant des instructions de programme, le programme informatique pouvant être chargé dans une unité de traitement de données et configuré pour provoquer une exécution du procédé selon l'une quelconque des revendications 11 à 16 lorsque le programme informatique est exécuté par l'unité de traitement de données.

Fig. 1

Fig. 2

Fig. 3

**400**

| 410 |
| --- |
| Receive channel coeffcients |

↓

| 420 |
| --- |
| Receive sums of transmission signals |

↓

| 440 |
| --- |
| Determine pre-distortion parameters |

Fig. 4

**500**

| 510 | |
| --- | --- |
| 520 PROC | 530 MEM |

Fig. 5

## REFERENCES CITED IN THE DESCRIPTION

### Patent documents cited in the description

- WO 2017198288 A1
- WO 2016132237 A1
- US 20120328050 A1
- KR 20140124178 A
- WO 2019117771 A1

### Non-patent literature cited in the description

- **S. CHOI ; E.-R. JEONG**. Digital Predistortion Based on Combined Feedback in MIMO Transmitters. *IEEE Communication Letters*, October 2012, vol. 16 (10), 1572-1575
- **A. PRATA et al.** Towards Circulator-Free Multi Antenna Transmitters for 5G. *IEEE MTT-S International Microwave Symposium*, 2017, 677-680
- **C. FAGER et al.** Prediction of Smart Antenna Transmitter Characteristics Using a New Behavioral Modeling Approach. *IEEE MTT-S International Microwave Symposium*, 2014, 1-4
- **P. LANDIN ; A. MAYER ; T. ERIKSSON**. MILA - A Noise Mitigation Technique for RF Power Amplifier Linearization. *International Multi-Conference on Systems, Signals & Devices, Conference on Communication & Signal Processing*, 2014